# EUROPEAN PATENT SPECIFICATION

(11) **EP 4 318 867 B1**
(45) Date of publication and mention of the grant of the patent: **24.06.2026**
(21) Application number: 23188763.9
(22) Date of filing: 31.07.2023
(51) Int. Cl.: H02J 7/44, H02J 7/70, H02J 7/34, H02J 7/00

(54) **PORTABLE POWER SUPPLY INCLUDING CAN BUS**
TRAGBARE STROMVERSORGUNG MIT CAN-BUS
ALIMENTATION ÉLECTRIQUE PORTABLE COMPRENANT UN BUS CAN

(30) Priority: 02.08.2022 US 202263370186 P; 07.10.2022 US 202263414035 P
(43) Date of publication of application: 07.02.2024
(73) Proprietor: Milwaukee Electric Tool Corporation, Brookfield, WI 53005 (US)
(72) Inventor: BROCHTRUP, David, Menomonee Falls, 53051 (US); TESCH, Benjamin C., Milwaukee, 53222 (US); HOCKERS, Brian M., Nashotah, 53058 (US)
(74) Representative: Forresters IP LLP

(56) References cited:
- EP-A1- 3 838 654
- DE-A1- 102019 209 072
- US-A1- 2011 234 165
- US-A1- 2021 305 838
- US-A1- 2021 376 634
- US-A1- 2022 045 614

## Description

### BACKGROUND ART

EP3838654 describes a distributed charging system comprising a plurality of charging stations transportable by charging station transport trucks, wherein each charging station transport truck has at least one lifting mechanism adapted to lift at least one charging station deployed on a ground floor onto a transport platform of the charging station transport truck for transport to another location, wherein each transportable charging station has at least one battery pack with rechargeable battery cells adapted to store electrical energy which is used to charge batteries of electrically powered vehicles connected to charging stations deployed on the ground floor.

US2011/234165 describes a modular charging system for series-connected battery packs is disclosed. An individual isolated charging module is connected across each cell in the pack. A battery cell and its corresponding charging module form a battery module assembly, a plurality of which are connected in series to form a complete battery pack of desired characteristics. A common input power input bus is shared between all charging modules and is connected in a daisy-chain fashion to a single input power source. A common isolated communications bus, which may be isolated CAN bus, is similarly shared and daisy-chained between all modules, connecting them to a monitoring processor. The monitoring processor is primarily intended to report the condition of each cell to the pack user or operator and need not actively control the charging of any individual cell. Each cell in a pack is optimally charged by the corresponding charging module. The overall system is readily scaled to any desired pack voltage and is well suited to mass production.

### SUMMARY

Control area network ("CAN") bus communications facilitate robust communications according to CAN protocol between electrical devices. A power supply (e.g., a portable power supply) including subsystems configured to communicate with one another over a CAN bus may result in a robust, resilient, portable power supply capable of providing power to various devices while providing user access to power supply statistics and information via the CAN bus.

The invention is as set out in the appended set of claims. The following embodiments are not necessary part of the claimed invention.

Embodiments described herein provide a portable power supply including subsystems configured to communicate via a CAN bus. A battery core of the power supply is configured to act as a DC power supply to external devices connected to the power supply via one or more charge ports. The battery core is configured to be charged using a power input, such as a plug from an AC power source (e.g., a 120V AC signal from a North American wall socket), that is provided to a battery core charger. A battery pack charger of the power supply is configured to provide a conditioned charging current to battery packs connected thereto via the one or more charge ports which are galvanically isolated from the CAN bus and battery core to protect users from high voltages. The charge ports are configured to draw power from the battery core, and in some cases, the core charger. A controller or battery management system ("BMS") is in electrical communication with both the battery core charger and the battery pack charger via the CAN bus. The BMS is configured to communicate with both the battery pack charger and the battery core charger according to the CAN protocol, and to manage the operation of both the battery pack charger and the battery core charger. A human machine interface ("HMI"), such as a touchpad or touchscreen, is also in communication with the CAN bus, via a galvanically isolating connection, and is made available to a user of the portable power supply. The HMI is configured to display status data, statistics, and other information communicated over the CAN bus by the battery core charger, the BMS, and the battery pack charger. The HMI is also configured to allow the user to input control commands or information requests to the CAN bus for execution by one or more of the BMS, the battery core charger, or the battery pack charger.

Embodiments described herein provide a portable power supply including a housing and a control area network ("CAN") bus disposed in the housing. A battery core is disposed in the housing and is configured to be charged by a battery core charger. A battery pack charger is connected to the battery core via a power line and to the CAN bus via a galvanically isolated barrier. The battery pack charger includes one or more charging modules. A battery management system is connected to the battery pack charger via the CAN bus and the power line, and is configured to control an operation of the battery pack charger and the battery core charger. A human machine interface is connected to the battery management system via the CAN bus, and is configured to allow a user to generate one or more control commands or information requests on the CAN bus for execution by one or more of the battery management system, battery core charger, or battery pack charger.

In some aspects, the galvanically isolated barrier of the portable power supply is a DC/DC converter that voltage isolates the battery pack charger from the CAN bus, the battery pack charger configured to charge a battery pack.

In some aspects, the battery management system of the portable power supply is configured to communicate with both the battery pack charger and the human machine interface using CAN protocol.

In some aspects, the battery management system portable power supply is connected to the battery pack charger via a galvanically isolated CAN transceiver.

In some aspects, the portable power supply further includes an electronic controller disposed in the battery pack charger and connected to the CAN transceiver, the electronic controller configured to determine that a charging port of the one or more charging modules is being used.

In some aspects, the portable power supply is further configured to determine a type of a battery pack connected to the charging port.

In some aspects, the electronic controller of the portable power supply of claim is further configured to determine a charging state of a battery pack connected to the charging port, and communicate the charging state to the human machine interface using CAN protocol, wherein the charging state is at least one of no pack present, initializing, flat pack recovery, normal rate bulk charge, taper charge, fully charged, maintenance charge, waiting to charge, charger faulted, pack faulted, pack too hot/cold, charger too hot/cold, or balancing pack cells.

Embodiments, not being the invention alone. described herein provide a method of initiating a charging of a battery pack. The method includes receiving, at a battery management system via a CAN bus, a notification of a connection of a battery pack from a battery pack charger. The method further includes receiving, at the battery management system via the CAN bus, a battery pack type or battery charge level from the battery pack charger, and receiving, at the battery management system via the CAN bus, a start charge command from a human machine interface. The method further includes delivering, via the battery pack charger, a charging current from a power source to the battery pack charger based on the start charge command. The battery pack charger of this method is galvanically isolated from the power source.

In some aspects, the method further includes controlling, via the battery management system, the battery pack charger to start charging the battery pack based on the start charge command.

In some aspects, the method further includes receiving, at the battery management system, a battery pack charging state from the battery pack charger.

In some aspects, the power source is a battery core of a portable power source.

In some aspects, the battery management system and the battery pack charger are both onboard a portable power source.

In some aspects, the CAN bus is onboard a portable power source.

In some aspects, the battery pack charger is galvanically isolated from the power source by a DC/DC converter that voltage isolates the battery pack charger from the CAN bus, the battery pack charger configured to charge a battery pack.

In some aspects, the battery management system is connected to the battery pack charger via a galvanically isolated CAN transceiver.

Before any embodiments are explained in detail, it is to be understood that the embodiments are not limited in application to the details of the configurations and arrangements of components set forth in the following description or illustrated in the accompanying drawings. The embodiments are capable of being practiced or of being carried out in various ways. Also, it is to be understood that the phraseology and terminology used herein are for the purpose of description and should not be regarded as limiting. The use of "including," "comprising," or "having" and variations thereof are meant to encompass the items listed thereafter and equivalents thereof as well as additional items. Unless specified or limited otherwise, the terms "mounted," "connected," "supported," and "coupled" and variations thereof are used broadly and encompass both direct and indirect mountings, connections, supports, and couplings.

Unless the context of their usage unambiguously indicates otherwise, the articles "a," "an," and "the" should not be interpreted as meaning "one" or "only one." Rather these articles should be interpreted as meaning "at least one" or "one or more." Likewise, when the terms "the" or "said" are used to refer to a noun previously introduced by the indefinite article "a" or "an," "the" and "said" mean "at least one" or "one or more" unless the usage unambiguously indicates otherwise.

In addition, it should be understood that embodiments may include hardware, software, and electronic components or modules that, for purposes of discussion, may be illustrated and described as if the majority of the components were implemented solely in hardware. However, one of ordinary skill in the art, and based on a reading of this detailed description, would recognize that, in at least one embodiment, the electronic-based aspects may be implemented in software (e.g., stored on non-transitory computer-readable medium) executable by one or more processing units, such as a microprocessor and/or application specific integrated circuits ("ASICs"). As such, it should be noted that a plurality of hardware and software based devices, as well as a plurality of different structural components, may be utilized to implement the embodiments. For example, "servers," "computing devices," "controllers," "processors," etc., described in the specification can include one or more processing units, one or more computer-readable medium modules, one or more input/output interfaces, and various connections (e.g., a system bus) connecting the components.

Relative terminology, such as, for example, "about," "approximately," "substantially," etc., used in connection with a quantity or condition would be understood by those of ordinary skill to be inclusive of the stated value and has the meaning dictated by the context (e.g., the term includes at least the degree of error associated with the measurement accuracy, tolerances [e.g., manufacturing, assembly, use, etc.] associated with the particular value, etc.). Such terminology should also be considered as disclosing the range defined by the absolute values of the two endpoints. For example, the expression "from about 2 to about 4" also discloses the range "from 2 to 4". The relative terminology may refer to plus or minus a percentage (e.g., 1%, 5%, 10%) of an indicated value.

It should be understood that although certain drawings illustrate hardware and software located within particular devices, these depictions are for illustrative purposes only. Functionality described herein as being performed by one component may be performed by multiple components in a distributed manner. Likewise, functionality performed by multiple components may be consolidated and performed by a single component. In some embodiments, the illustrated components may be combined or divided into separate software, firmware and/or hardware. For example, instead of being located within and performed by a single electronic processor, logic and processing may be distributed among multiple electronic processors. Regardless of how they are combined or divided, hardware and software components may be located on the same computing device or may be distributed among different computing devices connected by one or more networks or other suitable communication links. Similarly, a component described as performing particular functionality may also perform additional functionality not described herein. For example, a device or structure that is "configured" in a certain way is configured in at least that way but may also be configured in ways that are not explicitly listed.

Accordingly, in the claims, if an apparatus, method, or system is claimed, for example, as including a controller, control unit, electronic processor, computing device, logic element, module, memory module, communication channel or network, or other element configured in a certain manner, for example, to perform multiple functions, the claim or claim element should be interpreted as meaning one or more of such elements where any one of the one or more elements is configured as claimed, for example, to make any one or more of the recited multiple functions, such that the one or more elements, as a set, perform the multiple functions collectively.

Other aspects of the embodiments will become apparent by consideration of the detailed description and accompanying drawings.

### BRIEF DESCRIPTION OF THE DRAWINGS

FIG. 1A illustrates a perspective view of a portable power supply device, according to embodiments described herein.
FIG. 1B illustrates a portable power supply configured to receive a plurality of charging modules in a plurality of charge ports, according to embodiments described herein.
FIG. 1C illustrates the portable power supply of FIG. 1B including a plurality of charging modules connected to the charge ports, according to embodiments described herein.
FIG. 2A is a block diagram of a portable power supply including a battery core charger, a battery core, a battery management system, and battery pack charger, according to embodiments described herein.
FIG. 2B illustrates a detailed schematic of a battery core of the portable power supply connected to a battery management system, according to embodiments described herein.
FIG. 2C illustrates a battery pack charger of the portable power supply including a voltage isolated CAN communications circuit, according to embodiments described herein.
FIG. 3A is a block diagram of a power supply including power supply subsystems configured to communicate via a CAN bus of the portable power supply, according to embodiments described herein.
FIG. 3B illustrates a voltage isolated CAN transceiver disposed in a battery pack charger of the portable power supply, according to embodiments described herein.
FIG. 3C illustrates a CAN bus isolator disposed in a battery pack charger of the portable power supply, according to embodiments described herein.
FIG. 4 illustrates is a block circuit diagram for the portable power supply device of FIG. 1A, according to embodiments described herein.
FIG. 5 illustrates a graphical user interface of the portable power supply configured to display information communicated across the CAN bus, according to embodiments described herein.
FIG. 6 illustrates is a communication system for the portable power supply device of FIGS. 1A and an external device, according to some embodiments.
FIG. 7 is a flow chart illustrating CAN bus communication occurring between the battery management system and the battery pack charger when a charge module is connected to a charge port, according to embodiments described herein.

### DETAILED DESCRIPTION

Embodiments described herein relate to a portable power supply that includes a CAN bus configured to communicate data between system modules.

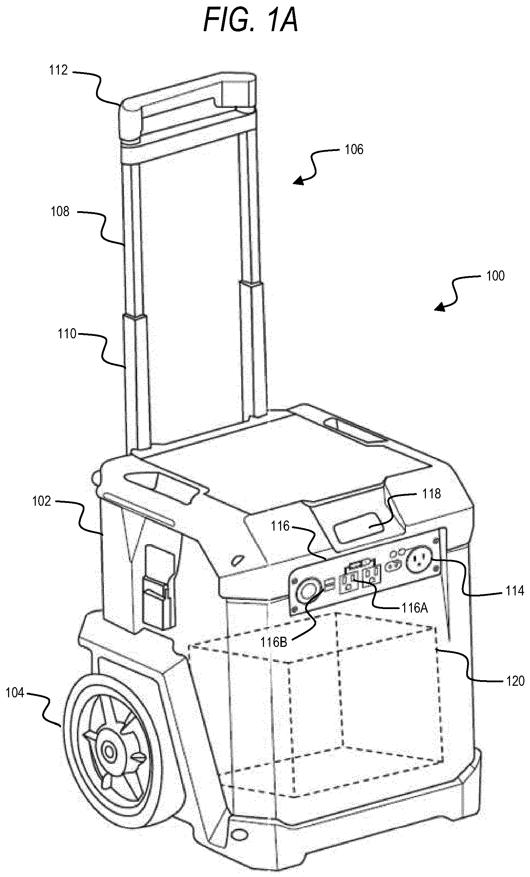

FIG. 1A illustrates a portable power supply device or power supply 100. The power supply 100 includes, among other things, a housing 102. In some embodiments, the housing 102 includes one or more wheels 104 and a handle assembly 106. In the illustrated embodiment, the handle assembly 106 is a telescoping handle movable between an extended position and a collapsed position. The handle assembly 106 includes an inner tube 108 and an outer tube 110. The inner tube 108 fits inside the outer tube 110 and is slidable relative to the outer tube 110. The inner tube 108 is coupled to a horizontal holding member 112. In some embodiments, the handle assembly 106 further includes a locking mechanism to prevent inner tube 108 from moving relative to the outer tube 110 by accident. The locking mechanism may include notches, sliding catch pins, or another suitable locking mechanism to inhibit the inner tube 108 from sliding relative to the outer tube 110 when the handle assembly 106 is in the extended position and/or in the collapsed position. In practice, a user holds the holding member 112 and pulls upward to extend the handle assembly 106. The inner tube 108 slides relative to the outer tube 110 until the handle assembly 106 locks in the extended position. The user may then pull and direct the power supply 100 by the handle assembly 106 to a desired location. The wheels 104 of the power supply 100 facilitate such movement.

The housing 102 of power supply 100 further includes a power input unit 114, a power output unit 116, and a display 118. In the illustrated embodiment, the power input unit 114 includes multiple electrical connection interfaces configured to receive power from an external power source. In some embodiments, the external power source is a DC power source. For example, the DC power source may be one or more photovoltaic cells (e.g., a solar panel), an electric vehicle ("EV") charging station, or any other DC power source. In some embodiments, the external power source is an AC power source. For example, the AC power source may be a conventional wall outlet, such as a 120 V outlet or a 240 V outlet, found in North America. As another example, the AC power source may be a conventional wall outlet, such as a 220V outlet or 230V outlet, found outside of North America. In some embodiments, the power input unit 114 is replaced by or additionally includes a cable configured to plug into a conventional wall outlet. In some embodiments, the power input unit 114 further includes one or more devices, such as antennas or induction coils, configured to wirelessly receive power from an external power source. The power received by the power input unit 114 may be used to charge a core battery or battery core 120, disposed within the housing 102 of power supply 100.

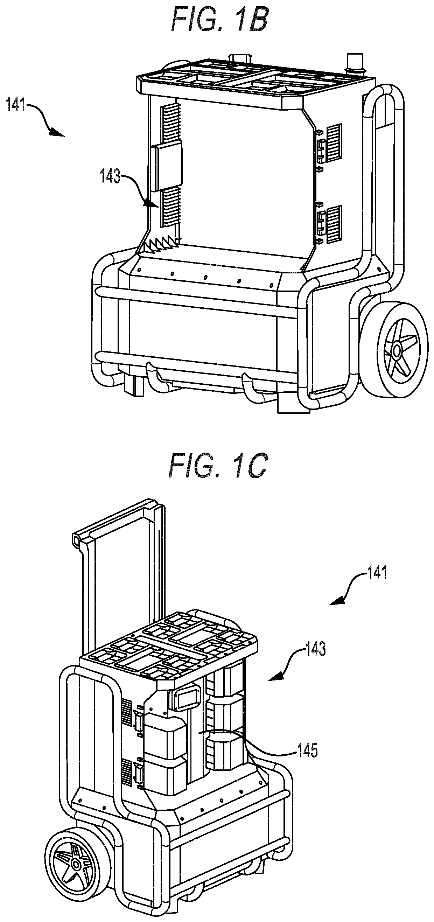

The power received by the power input unit 114 may also be used to provide power to one or more devices connected to the power output unit 116. The power output unit 116 includes one more power outlets. In the illustrated embodiment, the power output unit 116 includes a plurality of AC power outlets 116A and DC power outlets 116B. It should be understood that number of power outlets included in the power output unit 116 is not limited to the power outlets illustrated in FIG. 1. For example, in some embodiments of the power supply 100, the power output unit 116 may include more or fewer power outlets than the power outlets included in the illustrated embodiment of power supply 100.

In some embodiments, the power output unit 116 is configured to provide power output by the battery core 120 to one or more peripheral devices. In some embodiments, the power output unit 116 is configured to provide power provided by an external power source directly to one or more peripheral devices. The one or more peripheral devices may be a smartphone, a tablet computer, a laptop computer, a portable music player, a power tool, a power tool battery pack, a power tool battery pack charger, or the like. The peripheral devices may be configured to receive DC and/or AC power from the power output unit 116.

In some embodiments, the DC power outlets 116B also include one or more receptacles for receiving and charging power tool battery packs. In such embodiments, power tool battery packs received by, or connected to, the battery pack receptacles 116B are charged with power output by the battery core 120 and/or power received directly from the external power source. In some embodiments, power tool battery packs connected to the battery pack receptacles 116B are used to provide power to the battery core 120 and/or one or more peripheral devices connected to outlets of the power output unit 116. The battery pack receptacles 116B may include guide rails to receive slide-on style battery packs and latching mechanisms to secure the battery pack to the receptacle 116B. In such embodiments, the power supply 100 includes a plurality of charging modules or charging blocks for charging various battery packs. The charging modules can have different power ratings and can be interchangeable within different charging slots within the power supply 100. As a result, the power supply 100 can be configured with various combinations of battery pack chargers for charging battery packs of different voltages, charging at different rates, etc.

In some embodiments, the power output unit 116 includes tool-specific power outlets. For example, the power output unit may include a DC power outlet used for powering a welding tool. In some embodiments, the DC power outlets 116B are configured to support charging of battery packs with various power ratings (e.g., 12V, 18V, etc.).

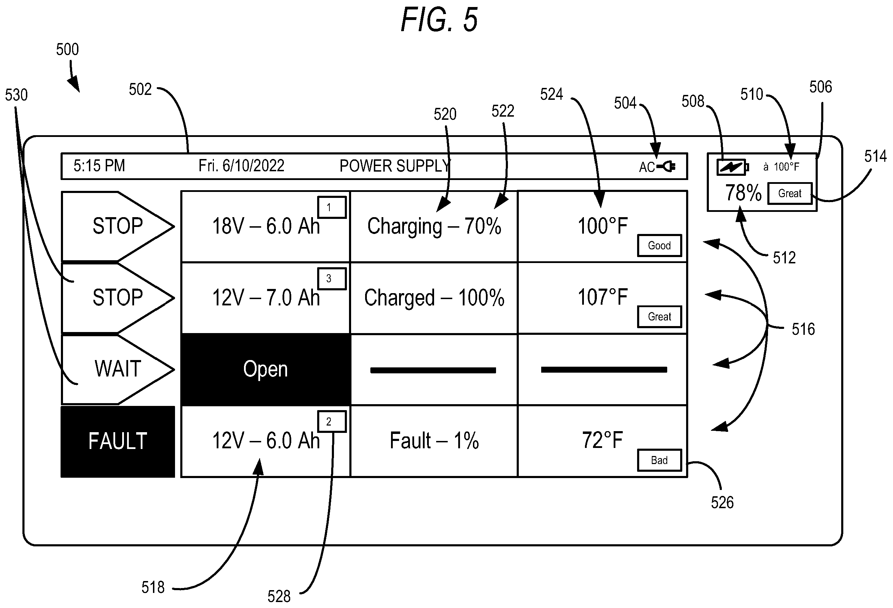

A display 118 is configured to indicate a state of the power supply 100 to a user, such as state of charge of the battery core 120 and/or fault conditions. In some embodiments the display 118 includes one or more light-emitting diode ("LED") indicators configured to illuminate and display a current state of charge of battery core 304. In some embodiments, the display 118 is, for example, a liquid crystal display ("LCD"), a light-emitting diode ("LED") display, an organic LED ("OLED") display, an electroluminescent display ("ELD"), a surface-conduction electron-emitter display ("SED"), a field emission display ("FED"), a thin-film transistor ("TFT") LCD, an electronic ink display, etc. In some embodiments, the display 118 is a touch screen configured to be used as a human-machine interface. The display 118 may be configured to display a graphical user interface further described below with regard to FIG. 5. The power supply 100 may include user input components such as keys, trackpads, dials, knobs, touchscreens, etc. for accepting user input and updating the display 118. In other embodiments, the power supply 100 does not include a display.

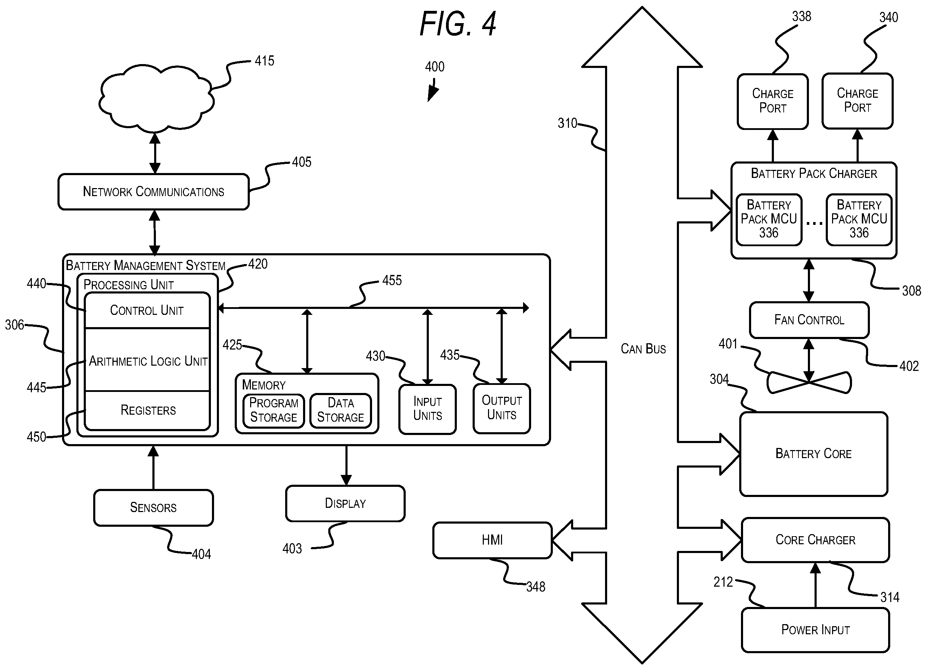

FIG. 1B and 1C illustrate another embodiment of a power supply 141 that is similar to the power supply 100 and which may include similar features. The power supply 141 may further include a compartment 143 that is configured to receive one or more charging modules 145. For example, the power supply 100, 141 may be configured with any combination of charging modules (e.g., 12V charging modules, 18V charging modules, etc.). The power supply 141 distributes, for example, a 24 V bus to the charging modules 145. In some embodiments, one or more of the charging modules accommodate one or more stem type battery packs or slide-on battery packs, or a combination of one or more stem battery packs and one or more slide-on battery packs, having a rated voltage between 3V to 21V (e.g., 12V, 18V, etc.) The charging modules may be configured to provide a charging current to a battery pack when the battery pack is received by at least one of the charging modules 145. One or more of the charging modules 145may be electrically coupled to one or more charging ports (e.g., charging port 338 [see FIG. 4]). The charging ports may include at least one USB C charging port that provides between 3.3 V and 21 V to a device coupled to the USB C charging port, and/or at least one USB A charging port that provides 5 V at 2.4 Amps to a device coupled to the USB A charging port. Devices may be electrically coupled to the charging ports via charging cables. One or more of the charging modules 145 may include a fan (e.g., fan 401 [see FIG. 4]) for cooling a battery pack. The fan may be controlled by a controller of the power supply 100 and may automatically turn on when the battery pack is inserted into one or more of the charging modules, or when a sensor coupled to the controller senses that the battery pack's temperature has reached a certain threshold value.

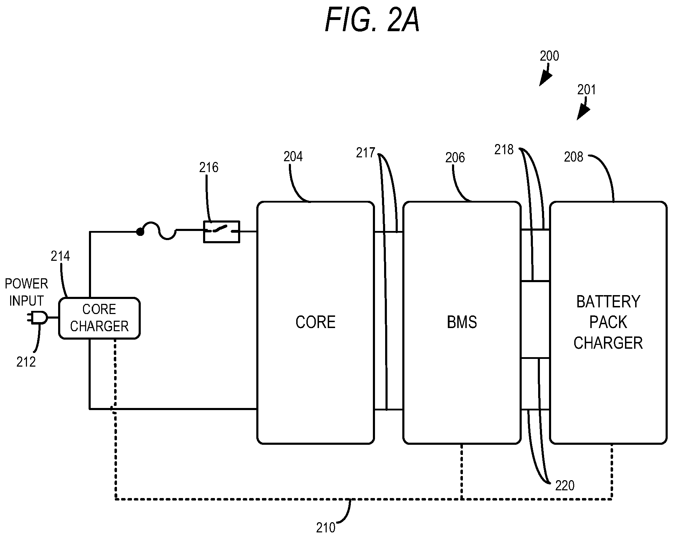

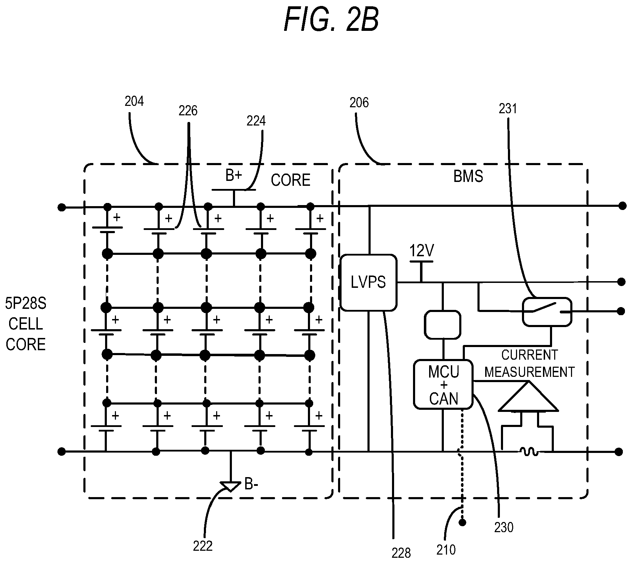

FIG. 2A illustrates a block diagram 200 of a portable power supply 201 (e.g., power supply 100, 141) including a battery core 204, a battery management system ("BMS") 206, and a battery pack charger 208, each connected to a CAN bus 210. A power input 212 (e.g., a plug configured to draw electrical current through a wall socket) is connected to a core charger 214 configured to provide a charging current to the battery core 204. As will described in greater detail below, the core charger 214 may communicate with the BMS 206 and the battery pack charger 208 for the purpose of monitoring the health of the battery core and managing the battery core and battery pack charging processes. A power supply disconnect switch 216 may be configured to disconnect the battery core 204, the BMS 206, and the pack charger 208 from current supplied by the core charger 214 via the power input 212. Power lines 217 are configured to provide current from the battery core 204 or the core charger 214 to the BMS 206 and the battery pack charger 208. Power lines 218 and 220 are configured to provide current from the BMS 206 to the battery pack charger 208. For example, the power lines 218 may be configured to supply current supplied by the battery core 204, or in some cases the core charger 214, directly to the battery pack charger 208, while power lines 220 are configured to provide, for example, a 12V signal, produced by a low-voltage power supply ("LPVS") 228 (see FIG. 2B), to the battery pack charger 208.

FIG. 2B illustrates a detailed schematic of the battery core 204 of the portable power supply 141 connected to the battery management system 206. The battery core 204 includes a positive terminal 224 and a negative terminal 222. The battery core 204 further includes a plurality of core cells 226 connected in series and parallel and configured to be charged by the core charger 214. Although illustrated as being connected in series and parallel, the core cells 226 may be electrically connected in series, in parallel, and/or a combination thereof. In some embodiments, the core cells 226 are implemented as rechargeable 24V groups or packs. In some embodiments, the rechargeable groups or packs may be relatively high voltage (e.g., 72V, 100V, 120V, 240V, etc.). Additionally, the battery core 204 may include as many core cells 226 as desired. For example, the battery core 204 may include two, three, four, ten, twenty, twenty-three, twenty-eight, forty-six, seventy or more battery cells electrically connected in series.

The core cells 226 included in the battery core 204 may be rechargeable battery cells having a lithium ion chemistry, such as lithium phosphate or lithium manganese. In some embodiments, the core cells 226 may have lead acid, nickel cadmium, nickel metal hydride, and/or other chemistries. In some embodiments, the core cells 226 are pouch battery cells (e.g., lithium-based pouch battery cells). Each core cell 226 in the battery core 204 has an individual nominal voltage. The nominal voltage of an individual core cell 226 included in the battery core 204 may be, for example, 4.2V, 4V, 3.9V, 3.6V, 2.4V, or some other voltage value. Naturally, the nominal voltages of the individual core cells 226 included in each group or pack may be stacked. For example, if a group or pack of core cells 226 includes two core cells 226 having nominal voltages of 4V, and the two core cells 226 are connected in series, voltage of the group or pack of core cells 226 is equal to 8.0V. Additionally, the amp-hour capacity, or capacity, of battery core 204 may be increased by adding core cells 226 connected in a parallel-series combination to the battery core 204.

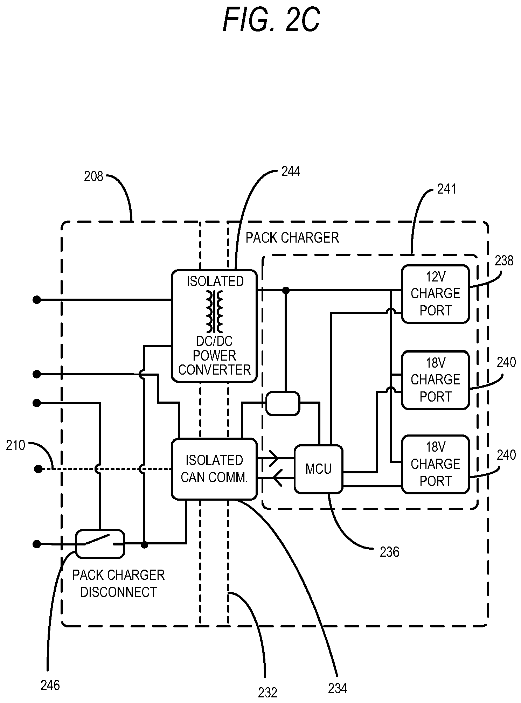

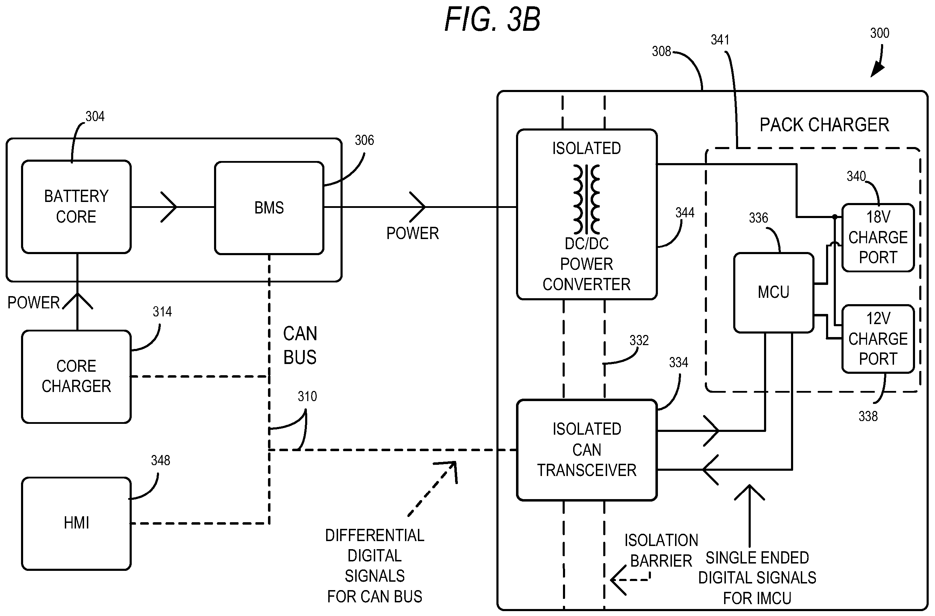

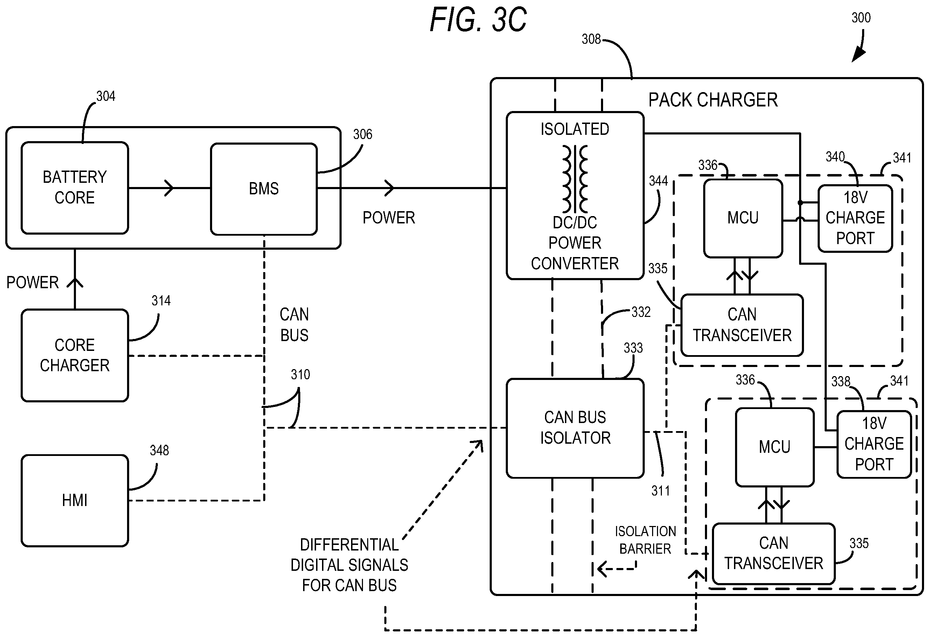

The BMS 206 is configured to provide current and voltage, as needed, from the battery core charger 214, the battery core 204, or the LVPS 228 to the battery pack charger 208. For example, the LVPS may be configured to provide a 12V power output to a galvanic isolation circuit (referred to herein generally as a "galvanic isolation barrier") such as a galvanically isolated CAN transceiver (see FIG. 3B) or a galvanic isolator circuit for a continuation of the CAN bus itself (see FIG. 3C). The BMS may also include a controller or microcontroller ("MCU") and CAN transceiver 230 configured to communicate according to the CAN protocol with the battery core charger 214 and the battery pack charger 208 to manage the provision of current from the battery core charger 214 to the battery core 204, and from the battery core 204 and the battery core charger 214 to the battery pack charger 208. The MCU and CAN transceiver 230 are also configured to measure current drawn by the battery pack charger 208 and to manipulate a BMS disconnect switch 231 based on the current measurement. For example, if the current drawn by the battery pack charger 208 spikes to an unsafe level (e.g., greater than 18 Amperes), the MCU and CAN transceiver 230 may close the BMS disconnect switch 231, which may cause a battery pack charger disconnect switch 246 (shown in FIG. 2C) to open, thereby preventing the flow of charging current to a charging port (see FIG. 2C). Current drawn by the battery pack charger 208 may also be measured with respect to the battery core 204, and used by the BMS 206 for determining the state of charge of the battery core 204. Additionally, in some embodiments, in order to prevent the battery pack charger 208 from draining the battery core 204 when the battery pack charger 308 is not in active operation, the BMS 206 closes the BMS disconnect switch 231, which causes the battery pack charger disconnect switch 246 to disconnect the battery core 204.

FIG. 2C illustrates the battery pack charger 208 of the portable power supply 201 including a galvanic isolation barrier 232 configured to galvanically isolate a CAN communications circuit 234 (e.g., a CAN transceiver) from the CAN bus 310 itself. As will be described later, the configuration shown is not the only configuration contemplated herein. For example, as will be described below, a galvanically isolated continuation of the CAN bus 311 (see FIG. 3C) may extend into the battery pack charger 208, and a plurality of CAN transceivers 335 (see FIG. 3C) in the battery pack charger may be configured to communicate with the BMS 206 and the battery core charger 214 via the galvanically isolated CAN bus continuation. The CAN communications circuit 234 is also configured to communicate via CAN protocol with a battery pack charger microcontroller 236 connected to a plurality of battery charging ports 238, 240. The charging ports 238, 240 are configured to charge devices connected to one or more charging modules 241 with an appropriate charging current at a specified voltage (e.g., 12V, 18V, etc.). In some embodiments, the charging modules 241 may be added to or removed from the battery pack charger 208 as desired. The battery pack charger microcontroller 236 is configured to control the charging ports 238, 240 (e.g., start charge, stop charge, pause charge, reset charge, etc.). The battery pack charger microcontroller 236 is configured to accept and execute CAN commands received from the BMS 206 via the CAN communications circuit 234. In this way the BMS 206 may manage the operation of charging ports 238, 240, via the battery pack charger microcontroller 236. A DC/DC power converter 244 is configured to condition current received from the BMS 206 to ensure an appropriate voltage charging signal is provided to the charging ports 238, 240. The battery pack MCU 236 may be configured to selectively interrupt the flow of current to charging ports 238, 240 in response to the conditioned current signal to protect one or more devices connected to the charging ports 238, 240. A battery pack charger disconnect 246 is configured to open in response to a signal received from the BMS disconnect switch 231, as described above, thereby preventing the flow of charging current to the charging ports 238, 240.

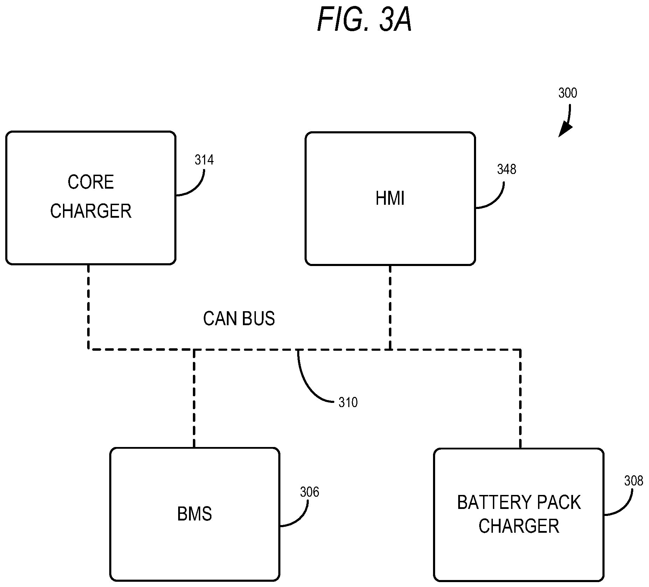

FIG. 3A is a high-level block diagram of an embodiment of a power supply 300 (e.g., power supply 100, 141, 201) including a CAN bus. The power supply 300 includes power supply subsystems including a BMS 306, a battery pack charger 308, a battery core charger 314, and a human machine interface ("HMI") 348, all configured to communicate with one another according to CAN protocol via a CAN bus 310. Here, the BMS 306, battery pack charger 308, and battery core charger 314 may be configured to operate according their descriptions with respect to FIGS. 2A-2C. The HMI 348 includes the display 118 taken together with an input device (e.g., keys, a touch pad, a touch screen, etc.) to allow a user of the power supply 300 to input charging commands. The charging commands may be translated by a CAN transceiver of the HMI and communicated over the CAN bus 310 to the appropriate power supply subsystem (e.g., BMS 306, battery pack charger 308, battery core charger 314, etc.) to control the operation of those subsystems or to request information related to those subsystems. This feature will be described in greater detail with respect to FIG. 5.

In some embodiments, the CAN bus 310 is made inaccessible to users due to the voltages associated with the CAN bus 310. In such embodiments, a combination of a galvanic isolation barrier (232) and an MCU in the battery pack charger 308 may facilitate safe CAN communications between the CAN bus 310 and one or more charge ports 238, 240 configured to accept a chargeable device. This way, ports accessible to a user may still allow devices connected to the charge port 238, 240 to communicate over the CAN bus 310.

FIG. 3B is a block diagram of an embodiment of the power supply 300 wherein the battery pack charger 308 includes a single battery pack MCU or controller 336. The core charger 314 is configured to deliver a charging current to the battery core 304 of the power supply 300. The battery core 304 is configured to be used as a DC power supply by the BMS 306. The BMS 306 is configured to draw DC from the battery core 304 and provide it as power to the battery pack charger 308, as described with reference to FIGS. 2A-2C. In some cases, the BMS 306 is configured to draw a charging current from the battery core charger 314 to charge a charging load via the battery pack charger 308. For example, if the power input 212 is drawing power from an external source (e.g., a wall socket) while the battery core 304 is fully charged and a charging load is connected to battery pack charger 308 via one of charge ports 340, 338, the power supply 300 may direct current output by the core charger 314 to the battery pack charger 308 to charge the charging load.

An isolated DC/DC converter 344 is configured to condition the power received from the BMS 306. The isolated DC/DC converter 344 is galvanically isolated from the CAN bus 310 and battery core 304, and produces an appropriate charging current for the charging ports 338, 340. For example, charging port 338 may have a 12V 3.0 Ah battery connected to it, and charging port 340 may have a 18V 3.0 Ah battery connected to it. In such a case, the isolated DC/DC converter 344 conditions the power received from the BMS 306 in order for the charge module 341 to safely charge each connected battery pack over time (e.g., using a cascaded constant current/constant voltage approach, also known as cascaded "CC-CV"). The battery charger MCU 336 is configured to monitor the charging ports 338, 340 and to communicate monitored data back to the BMS 306 via the CAN bus 310. In the embodiment shown, the battery charger MCU 336 is configured to communicate on the CAN bus 310 via an isolated CAN transceiver 334. The isolated CAN transceiver 334 is configured to prevent high voltages associated with the CAN bus 310, and which are potentially harmful to humans, from reaching the charge ports 338, 340. The isolated CAN transceiver 334 is also configured to receive CAN protocol messages directed at the battery pack charger 308 from the CAN bus 310, and to deliver them to the battery charger MCU 336 as digital signals.

FIG. 3C is a block diagram of another embodiment of the power supply 300. The embodiment shown is similar to that of FIG. 3B, except the power supply 300 includes a galvanic isolation circuit 333 acting as a galvanic isolation barrier 332 for a CAN bus continuation 311. In this embodiment, a plurality of charging modules 341, each capable of supporting multiple battery charger MCUs 336 and CAN transceivers 335, are used to deliver tailored CAN protocol communications to each charging port 338, 340 from the battery core charger 314, the BMS 306, or the HMI 348. This embodiment may provide a reduction in cost over the embodiment of FIG. 3B because there is no need for each CAN transceiver 335 to be individually galvanically isolated from the CAN bus 310.

FIG. 4 illustrates is a block circuit diagram for a power supply 400 (e.g., power supply 100, 141, 201, 300). The CAN bus 310 provides a means for communication between a plurality of subcomponents and peripherals, such as the battery core charger 314, the battery core 304, the BMS 306, and the HMI 348. Additionally, a fan 401 and fan control 402 are connected to the battery pack charger 308 and configured to cool battery packs connected to charge ports 338, 340, as needed. A display 403, a plurality of sensors 404, and a network communications module 405 may be connected to the BMS 306 and configured to display sensed information or information received by the BMS 306 via the CAN bus 310. The network communications module 405 may be used by the BMS 306 to communicate with a network 415 and download, for example, firmware updates.

In the embodiment shown, the network communications module 405 enables the BMS 306 to communicate with peripheral devices in the network, such as a smartphone or a server. The sensors 404 include, for example, one or more voltage sensors, one or more current sensors, one or more temperature sensors, etc. Each of the sensors 404 generates one or more output signals that are provided to the BMS 306 for processing and evaluation. HMI 348 is included to provide user control of the power supply 400, as described above. The HMI 348 can include any combination of digital and analog input devices required to achieve a desired level of control for the power supply 400. For example, the HMI 348 may include a plurality of knobs, a plurality of dials, a plurality of switches, a plurality of buttons, or the like. In some embodiments, the HMI 348 is integrated with the display 403 (e.g., as a touchscreen display).

The BMS 306 may include combinations of hardware and software that are operable to, among other things, control the operation of the power supply 400, communicate over the network 415, receive input from a user via the HMI 348, provide information to a user via the display 118, etc. For example, the BMS 306 may include, among other things, a processing unit 420 (e.g., a microprocessor, a microcontroller, an electronic processor, an electronic controller, or another suitable programmable device), a memory 425, input units 430, and output units 435. The processing unit 420 includes, among other things, a control unit 440, an arithmetic logic unit ("ALU") 445, and a plurality of registers 450 (shown as a group of registers in FIG. 4), and is implemented using a known computer architecture (e.g., a modified Harvard architecture, a von Neumann architecture, etc.). The processing unit 420, the memory 425, the input units 430, and the output units 435, as well as the various modules or circuits connected to the BMS 306 are connected by one or more control and/or data buses (e.g., common bus 455). The control and/or data buses are shown generally in FIG. 4 for illustrative purposes. Although the BMS 306 is illustrated in FIG. 4 as one controller, the BMS 306 could also include multiple controllers configured to work together to achieve a desired level of control for the power supply 400. As such, any control functions and processes described herein with respect to the BMS 306 could also be performed by two or more controllers functioning in a distributed manner.

The memory 425 may include a non-transitory computer readable medium and includes, for example, a program storage area and a data storage area. The program storage area and the data storage area may include combinations of different types of memory, such as a read only memory ("ROM"), a random access memory ("RAM") (e.g., dynamic RAM ["DRAM"], synchronous DRAM ["SDRAM"], etc.), electrically-erasable programmable ROM ("EEPROM"), flash memory, a hard disk, an SD card, or other suitable magnetic, optical, physical, or electronic memory devices. The processing unit 420 is connected to the memory 425 and is configured to execute software instructions that are capable of being stored in a RAM of the memory 425 (e.g., during execution), a ROM of the memory 425 (e.g., on a generally permanent basis), or another non-transitory computer readable medium such as another memory or a disc. Software included in the implementation of the power supply 100 and BMS 306 may be stored in the memory 425 of the BMS 306. The software may include, for example, firmware, one or more applications, program data, filters, rules, one or more program modules, and other executable instructions. The BMS 306 may be configured to retrieve from the memory 425 and execute, among other things, instructions related to the control processes and methods described herein. In other embodiments, the BMS 306 includes additional, fewer, or different components.

Information and commands from and to any of the components, subcomponents, systems, or subsystems shown in FIG. 4 may be communicated in CAN protocol via the CAN bus 310. For example, the following types of information may be gathered using sensors at any of the core charger 314, the battery core 304, the BMS 306, or the battery pack charger 308, or input by a user at the HMI 348, and communicated via the CAN bus 310 during regular operation or in response to a request made by a user via the HMI 348:
- which charge ports 338, 340 have battery packs installed/connected;
- battery pack type (e.g., style, voltage, capacity, etc.) of a battery pack connected to a given charge port 338, 340;
- status of connected battery pack charging process (e.g., no battery pack present, initializing, flat battery pack recovery, normal rate bulk charge, taper charge, battery pack fully charged, maintenance charge, waiting to charge, battery pack charger 308 faulted, battery pack faulted, battery pack too hot/cold, battery pack charger 308 too hot/cold, balancing battery pack cells);
- time spent charging connected battery pack;
- estimated time to fully charge connected battery pack;
- status of connected battery pack;
- estimated state of charge of battery pack;
- estimated state of health of connected battery pack;
- temperature of connected battery pack;
- speed of fan 401;
- present charge current of each charging port 338, 340;
- internal data log data from a connected battery pack;
- user selected charge port priority (e.g., which batteries charge first and at what rate);
- operating directives (e.g., start charging, stop charging, pause charging, or restart charging of a connected battery pack);
- heartbeat messages from battery pack charger 308 to the HMI 348 to indicate that the system is active (these may be configured to work like a dead man's switch: the battery pack charger 308 may be configured to shut down if it received no heartbeat message for some period of time);
- battery pack charger 308 temperature information (this may be used by fan control systems throughout the power supply 400);
- continuous time spent by the battery pack charger 308 not actively charging battery packs, or idle time (this may be used by a system-level sleep/wake control algorithm, or the BMS 306 might disconnect power from the battery pack charger 308 to conserve energy);
- diagnostic and data log information about the battery pack charger 308;
- firmware updates; and
- the current drawn by the battery pack charger 308 from the battery core 304 (may be used to determine the core's state of charge).

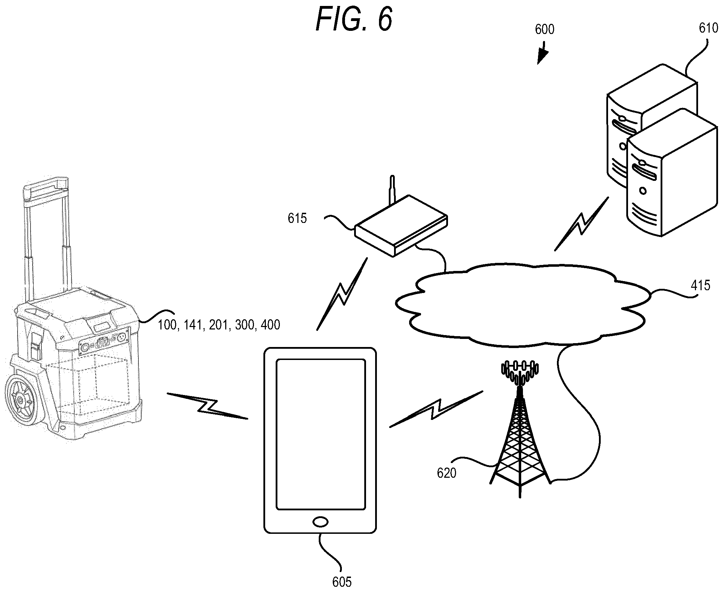

Any of the aforementioned types of information may be displayed on the display 118 or communicated a user device such as a mobile phone (see FIG. 6).

FIG. 5 illustrates a graphical user interface ("GUI") 500 of the portable power supply 400 configured to display information communicated across the CAN bus 310. The GUI 500 includes a general information bar 502 configured to display the current time and date, as well as a power input icon 504 indicating whether the power supply 400 is currently plugged into an external power supply (e.g., an AC power source) via the power input 212. A core information pane 506 contains current information about the battery core 304. A core charging icon 508 indicates whether the battery core 304 is currently charging, and a battery core indicator 510 indicates the current temperature of the battery core 304. A core state of charge indicator 512 indicates a level of charge (e.g., percentage state of charge) of the battery core 304, and a battery health indicator 514 indicates the battery core 304's state of health.

A plurality of charge port rows 516 contain information pertaining to battery packs connected to the battery pack charger 308 via charge ports 338, 340. When a battery pack is connected to the battery pack charger 308, information including the battery pack type 518 is displayed (e.g., operating voltage and capacity, the battery pack charging status 520 and state of charge 522). The battery pack temperature 524 and state of health 526 (e.g., great, good, bad, or dead) is also displayed. A charging priority 528, chosen by a user via the HMI 348, is displayed, indicating an order in which the connected battery packs are to be charged. User control options 530 are also displayed by the GUI 500. In the embodiment shown, a user is given the option, via the GUI 500, to stop charging certain battery packs. In some embodiments, the HMI 348 is embedded as a touch screen in the display 118, and the user can simply tap the "STOP" user option 530 of the GUI 500 to stop the charging of a battery pack associated with the user option 530.

FIG. 6 is a communication system 600 for the portable power supply 100, 141, 201, 300, 400 described herein. The communication system 600 includes at least one power supply 100, 141, 201, 300, 400 and an external device 605. Each power supply 100, 141, 201, 300, 400 and the external device 605 can communicate wirelessly while they are within a communication range of each other. Each power supply 100, 141, 201, 300, 400 may communicate power supply status, power supply operation statistics, power supply identification, power supply sensor data, stored power supply usage information, power supply maintenance data, and the like.

Using the external device 605, a user can access the parameters of the power supply 100, 141, 201, 300, 400. With the parameters (e.g., power supply operational data or settings), a user can determine how the power supply 100, 141, 201, 300, 400 has been used, whether maintenance is recommended or has been performed in the past, and identify malfunctioning components or other reasons for certain performance issues. The external device 605 can also transmit data to the power supply 100, 141, 201, 300, 400 for power supply configuration, firmware updates, or to send commands. The external device 605 also allows a user to set operational parameters, safety parameters, operating modes, and the like for the power supply 100, 141, 201, 300, 400.

The external device 605 is, for example, a smart phone (as illustrated), a laptop computer, a tablet computer, a personal digital assistant (PDA), or another electronic device capable of communicating wirelessly with the power supply 100, 141, 201, 300, 400 and providing a user interface. The external device 605 provides the user interface and allows a user to access and interact with the power supply 100, 141, 201, 300, 400. In some embodiments, the user interface corresponds to the GUI 500 in FIG. 5. The external device 605 can receive user inputs to determine operational parameters, enable or disable features, and the like. The user interface of the external device 605 provides an easy-to-use interface for the user to control and customize operation of the power supply 100, 141, 201, 300, 400. The external device 605, therefore, grants the user access to the power supply operational data of the power supply 100, 141, 201, 300, 400, and provides a user interface such that the user can interact with, for example, the BMS 306 of the power supply 300.

In addition, as shown in FIG. 6, the external device 605 can also share the power supply operational data obtained from the power supply 100, 141, 201, 300, 400 with a remote server 610 connected through the network 415. The remote server 610 may be used to store the tool operational data obtained from the external device 605, provide additional functionality and services to the user, or a combination thereof. In some embodiments, storing the information on the remote server 610 allows a user to access the information from a plurality of different locations. In some embodiments, the remote server 610 collects information from various users regarding their power supplies and provide statistics or statistical measures to the user based on information obtained from the different power supplies. For example, the remote server 610 may provide statistics regarding the experienced efficiency of the power supply 100, 141, 201, 300, 400, typical usage of the power supply 100, 141, 201, 300, 400, and other relevant characteristics and/or measures of the power supply 100, 141, 201, 300, 400. The network 415 may include various networking elements (routers 615, hubs, switches, cellular towers 620, wired connections, wireless connections, etc.) for connecting to, for example, the Internet, a cellular data network, a local network, or a combination thereof, as previously described. In some embodiments, the power supply 100, 141, 201, 300, 400 is configured to communicate directly with the remote server 610 through an additional wireless interface or with the same wireless interface that the power supply 100, 141, 201, 300, 400 uses to communicate with the external device 605.

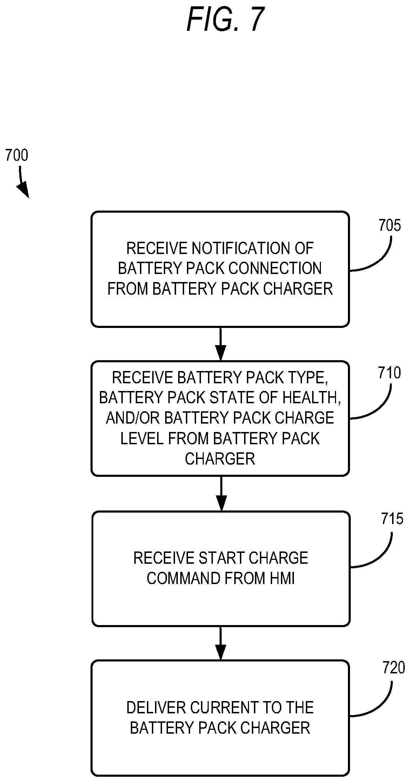

In some embodiments, the power supply 100, 141, 201, 300, 400 is configured to provide output power (e.g., from the battery core 120, 204, 304) until the battery core 120, 204, 304 reaches a low-voltage cutoff threshold. In embodiments where the power supply 100, 141, 201, 300, 400 received removable and rechargeable battery packs, the battery packs that are used to provide output power from the power supply 100, 141, 201, 300, 400 can be similarly discharged until reaching low-voltage cutoff thresholds. FIG. 7 is a flow chart illustrating CAN bus communication occurring between the BMS 306 and the battery pack charger 308 when a charge module 341 is connected to pack charger 308.

At block 705, the BMS 306 receives, via the CAN bus 310, an indication that a battery pack is connected to the battery pack charger 308.

At block 710, the BMS 306 receives, via the CAN bus 310, a battery pack type of the connected battery pack from the battery pack charger 308, a battery pack state of health of the connected battery pack from the battery pack charger 308, and/or a battery pack charge level of the connected battery pack from the battery pack charger 308.

At block 715, the BMS 306 receives, via the CAN bus 310, a start charge command from the HMI 348.

At block 720, the BMS 306 delivers, from the battery core 304 via the power lines 218, current to the battery pack charger 308.

Thus, embodiments described herein provide, among other things, a portable power supply including a CAN bus. Various features and advantages are set forth in the following claims.

## Claims

1. A portable power supply (100) comprising:
a housing (102);
a control area network ("CAN") bus (210) disposed in the housing (102);
a battery core (204, 304) disposed in the housing (102) and configured to be charged by a battery core charger (214, 314);
a battery pack charger (208, 308) connected to the battery core (204, 204) via a power line (217) and to the CAN (210, 310) bus and including one or more charging modules (145, 241, 341);
a battery management system (206, 306) connected to the battery pack charger (208, 308) via the CAN bus (210, 310) and the power line (217) and configured to control an operation of the battery pack charger (208, 308) and the battery core charger (214, 314); and
a human machine interface (348) connected to the battery management system (206, 306) via the CAN bus (210, 310) and configured to allow a user to generate one or more control commands or information requests on the CAN bus (210, 310) for execution by one or more of the battery management system (206, 306), battery core charger (214, 314), or battery pack charger (208, 308),
**characterised in that** the battery pack charger (208, 308) is connected to the CAN (210, 310) bus via a galvanically isolated barrier (232, 332).

2. The portable power supply (100) of claim 1, wherein the galvanically isolated barrier (232, 332) is a DC/DC converter (344) that voltage isolates the battery pack charger (208, 308) from the CAN bus (210, 310), the battery pack charger (208, 308) configured to charge a battery pack.

3. The portable power supply (100) of claim 1, wherein the battery management system (206, 306) is configured to communicate with both the battery pack charger (208, 308) and the human machine interface (348) using CAN protocol.

4. The portable power supply (100) of claim 1, wherein the battery management system (206, 306) is connected to the battery pack charger (208, 308) via a galvanically isolated CAN transceiver (230, 334).

5. The portable power supply (100) of claim 4, further comprising an electronic controller (336, 420) disposed in the battery pack charger (208, 308) and connected to the CAN transceiver (230, 334), the electronic controller (336, 420) configured to determine that a charging port (238, 240, 338, 340) of the one or more charging modules (145, 241, 341) is being used.

6. The portable power supply (100) of claim 5, wherein the electronic controller (336, 420) is further configured to determine a type of a battery pack connected to the charging port (238, 240, 338, 340).

7. The portable power supply (100) of claim 6, wherein the electronic controller (336, 420) is further configured to:
determine a charging state of a battery pack connected to the charging port (238, 240, 338, 340); and
communicate the charging state to the human machine interface (348) using CAN protocol,
wherein the charging state is at least one of initializing, flat pack recovery, normal rate bulk charge, taper charge, maintenance charge, waiting to charge, charger faulted, or charger too hot/cold.

8. The portable power supply (100) of claim 6, wherein the electronic controller (336, 420) is further configured to:
determine a charging state of a battery pack connected to the charging port (238, 240, 338, 340); and
communicate the charging state to the human machine interface (348) using CAN protocol, wherein the charging state is at least one of no pack present, initializing, flat pack recovery, normal rate bulk charge, taper charge, maintenance charge, waiting to charge, charger faulted, pack faulted, pack too hot/cold, charger too hot/cold, or balancing pack cells.

9. A method of initiating a charging of a battery pack using a portable power supply (100) including a control area network ("CAN") bus (210, 310), a battery core (204, 304), a battery pack charger (208, 308) connected to the battery core (204, 304) via a power line and to the CAN bus (210, 310) and including one or more charging modules (145, 241, 341), a battery management system (206, 306) connected to the battery pack charger (208, 308) via the CAN bus (210, 310) and the power line, and a human machine interface (348) connected to the battery management system (206, 306) via the CAN bus (210, 310), the method comprising:
charging, using a battery core charger (214, 314), the battery core (204, 304);
controlling, using the battery management system (206, 306), an operation of the battery pack charger (208, 308) and the battery core charger (214, 314); and
generating, based on user input at the human machine interface (348), one or more control commands or information requests on the CAN bus (210, 310) for execution by one or more of the battery management system (206, 306), battery core charger (214, 314), or battery pack charger (208, 308),
**characterised in that** the battery pack charger (208, 308) is connected to the CAN (210, 310) bus via a galvanically isolated barrier (232, 332).

10. The method of claim 9, further comprising:
receiving, at a battery management system (206, 306) via a CAN bus (210, 310), a notification of a connection of a battery pack from a battery pack charger (208, 308);
receiving, at the battery management system (206, 306) via the CAN bus (210, 310), a start charge command from a human machine interface (348);
controlling, via the battery management system (206, 306), the battery pack charger (208, 308) to start charging the battery pack based on the start charge command; and
delivering, via the battery pack charger (208, 308), a charging current from a power source to the battery pack charger (208, 308) based on the start charge command.

11. The method of claim 9, further comprising:
receiving, at the battery management system (206, 306), a battery pack charging (208, 308) state from the battery pack charger (208, 308).

12. The method of claim 9, wherein the battery management system (206, 306) and the battery pack charger (208, 308) are both onboard a portable power source.

13. The method of claim 9, wherein the CAN bus (210, 310) is onboard a portable power source.

14. The method of claim 9, wherein the battery pack charger (208, 308) is galvanically isolated from the power source by a DC/DC converter that voltage isolates the battery pack charger (208, 308) from the CAN bus (210, 310), the battery pack charger (208, 308) configured to charge a battery pack.

15. The method of claim 9, wherein the battery management system (206, 306) is connected to the battery pack charger (208, 308) via a galvanically isolated CAN transceiver (230, 334).

## Patentansprüche

1. Tragbare Stromversorgung (100), umfassend:
Ein Gehäuse (102);
ein im Gehäuse (102) angeordneter CAN-Bus (210);
ein im Gehäuse (102) angeordneter Batteriekern (204, 304), der so konfiguriert ist, dass er von einem Batteriekernladegerät (214, 314) geladen werden kann;
ein Batteriepackladegerät (208, 308), das über eine Stromleitung (217) mit dem Batteriekern und dem CAN-Bus (210, 310) verbunden ist und ein oder mehrere Lademodule (145, 241, 341) umfasst;
ein Batteriemanagementsystem (206, 306), das über den CAN-Bus (210, 310) und die Stromleitung (217) mit dem Batteriepackladegerät (208, 308) verbunden ist und so konfiguriert ist, dass es den Betrieb des Batteriepackladegeräts (208, 308) und des Batteriekernladegeräts (214, 314) steuert; und
eine Mensch-Maschine-Schnittstelle (348), die über den CAN-Bus (210, 310) mit dem Batteriemanagementsystem (206, 306) verbunden ist und so konfiguriert ist, dass ein Benutzer einen oder mehrere Steuerbefehle oder Informationsanforderungen über den CAN-Bus (210, 310) generieren kann, die von einem oder mehreren der folgenden Komponenten ausgeführt werden: Batteriemanagementsystem (206, 306), Batteriekernladegerät (214, 314) oder Batteriepackladegerät (208, 308),
**dadurch gekennzeichnet, dass** das Batteriepackladegerät (208, 308) über eine galvanisch getrennte Barriere (232, 332) mit dem CAN-Bus (210, 310) verbunden ist.

2. Tragbare Stromversorgung (100) nach Anspruch 1, wobei die galvanisch getrennte Barriere (232, 332) ein DC/DC-Wandler (344) ist, der das Batteriepackladegerät (208, 308) vom CAN-Bus (210, 310) spannungsisoliert, wobei das Batteriepackladegerät (208, 308) zum Laden eines Batteriepacks konfiguriert ist.

3. Tragbare Stromversorgung (100) nach Anspruch 1, wobei das Batteriemanagementsystem (206, 306) so konfiguriert ist, dass es sowohl mit dem Batteriepackladegerät (208, 308) als auch mit der Mensch-Maschine-Schnittstelle (348) über das CAN-Protokoll kommuniziert.

4. Tragbare Stromversorgung (100) nach Anspruch 1, wobei das Batteriemanagementsystem (206, 306) über einen galvanisch getrennten CAN-Transceiver (230, 334) mit dem Batteriepackladegerät (208, 308) verbunden ist.

5. Tragbare Stromversorgung (100) nach Anspruch 4, ferner eine elektronische Steuereinheit (336, 420) umfassend, die im Batteriepackladegerät (208, 308) angeordnet und mit dem CAN-Transceiver (230, 334) verbunden ist, wobei die elektronische Steuereinheit (336, 420) so konfiguriert ist, dass sie ermittelt, ob ein Ladeanschluss (238, 240, 338, 340) des einen oder mehrerer Lademodule (145, 241, 341) verwendet wird.

6. Tragbare Stromversorgung (100) nach Anspruch 5, wobei die elektronische Steuereinheit (336, 420) ferner so konfiguriert ist, dass sie den Typ eines an den Ladeanschluss (238, 240, 338, 340) angeschlossenen Batteriepacks ermittelt.

7. Tragbare Stromversorgung (100) nach Anspruch 6, wobei die elektronische Steuereinheit (336, 420) ferner konfiguriert ist, Folgendes zu tun:
Ermitteln eines Ladezustands eines an den Ladeanschluss (238, 240, 338, 340) angeschlossenen Batteriepacks; und
Kommunizieren des Ladezustands über das CAN-Protokoll an die Mensch-Maschine-Schnittstelle (348),
wobei der Ladezustand mindestens einer der folgenden ist: Initialisierung, Wiederherstellung des leeren Packs, normale Schnellladung, reduzierte Ladung, Erhaltungsladung, Warten auf den Ladevorgang, Ladegerät defekt oder Ladegerät zu heiß/kalt.

8. Tragbare Stromversorgung (100) nach Anspruch 6, wobei die elektronische Steuereinheit (336, 420) ferner konfiguriert ist, Folgendes zu tun:
Ermitteln eines Ladezustands eines an den Ladeanschluss (238, 240, 338, 340) angeschlossenen Batteriepacks; und
Kommunizieren des Ladezustands über das CAN-Protokoll an die Mensch-Maschine-Schnittstelle (348), wobei der Ladezustand mindestens einer der folgenden ist: Kein Pack vorhanden, Initialisierung, Wiederherstellung des leeren Packs, normale Schnellladung, reduzierte Ladung, Erhaltungsladung, Warten auf den Ladevorgang, Ladegerät defekt, Pack defekt, Pack zu heiß/kalt, Ladegerät zu heiß/kalt oder Ausgleich der Packzellen.

9. Verfahren zum Initiieren des Ladevorgangs eines Batteriepacks mittels einer tragbaren Stromversorgung (100), umfassend: Einen CAN-Bus (210, 310), einen Batteriekern (204, 304), ein Batteriepackladegerät (208, 308), das über eine Stromleitung mit dem Batteriekern (204, 304) und dem CAN-Bus (210, 310) verbunden ist, und mit einem oder mehreren Lademodul(en) (145, 241, 341), einem Batteriemanagementsystem (206, 306), das über den CAN-Bus (210, 310) und die Stromleitung mit dem Batteriepackladegerät (208, 308) verbunden ist, und einer Mensch-Maschine-Schnittstelle (348), die über den CAN-Bus (210, 310) mit dem Batteriemanagementsystem (206, 306) verbunden ist, wobei das Verfahren Folgendes umfasst:
Laden des Batteriekerns (204, 304) mit einem Batteriekernladegerät (214, 314);
Steuern eines Betriebs des Batteriepackladegeräts (208, 308) und des Batteriekernladegeräts (214, 314) unter Verwendung des Batteriemanagementsystems (206, 306); und
Generieren, auf Basis der Benutzereingaben an der Mensch-Maschine-Schnittstelle (348), eines oder mehrerer Steuerbefehle oder Informationsanforderungen über den CAN-Bus (210, 310) zur Ausführung durch eines oder mehrere der folgenden Systeme: Batteriemanagementsystem (206, 306), Batteriekernladegerät (214, 314) oder Batteriepackladegerät (208, 308),
**dadurch gekennzeichnet, dass** das Batteriepackladegerät (208, 308) über eine galvanisch getrennte Barriere (232, 332) mit dem CAN-Bus (210, 310) verbunden ist.

10. Verfahren nach Anspruch 9, ferner umfassend:
Empfangen, an einem Batteriemanagementsystem (206, 306), über einen CAN-Bus (210, 310) einer Benachrichtigung einer Verbindung eines Batteriepacks eines Batteriepackladegeräts (208, 308);
Empfangen eines Startladebefehls von einer Mensch-Maschine-Schnittstelle (348) am Batteriemanagementsystem (206, 306) über den CAN-Bus (210, 310);
Steuern des Batteriepackladegeräts (208, 308) über das Batteriemanagementsystem (206, 306) zum Starten des Ladevorgangs des Batteriepacks auf Basis des Startladebefehls; und
Bereitstellen eines Ladestroms, über das Batteriepackladegerät (208, 308), von einer Stromquelle zum Batteriepackladegerät (208, 308) auf dem Startladebefehl basierend.

11. Verfahren nach Anspruch 9, ferner umfassend:
Empfangen, am Batteriemanagementsystems (206, 306), vom Batteriepackladegerät (208, 308) eines Zustands des Batteriepackladegeräts (208, 308).

12. Verfahren nach Anspruch 9, wobei sich das Batteriemanagementsystem (206, 306) und das Batteriepackladegerät (208, 308) beide an Bord einer tragbaren Stromquelle befinden.

13. Verfahren nach Anspruch 9, wobei sich der CAN-Bus (210, 310) an Bord einer tragbaren Stromquelle befindet.

14. Verfahren nach Anspruch 9, wobei das Batteriepackladegerät (208, 308) galvanisch von der Stromquelle durch einen DC/DC-Wandler getrennt ist, der das Batteriepackladegerät (208, 308) spannungsisoliert vom CAN-Bus (210, 310) trennt, wobei das Batteriepackladegerät (208, 308) zum Laden eines Batteriepacks konfiguriert ist.

15. Verfahren nach Anspruch 9, wobei das Batteriemanagementsystem (206, 306) über einen galvanisch getrennten CAN-Transceiver (230, 334) mit dem Batteriepackladegerät (208, 308) verbunden ist.

## Revendications

1. Alimentation portable (100), comprenant :
un boîtier (102) ;
un bus de réseau de commande (CAN) (210) disposé dans le boîtier (102) ;
un noyau de batterie (204, 304) disposé dans le boîtier (102) et configuré pour être rechargé par un chargeur de noyau de batterie (214, 314) ;
un chargeur de bloc-batterie (208, 308) connecté au noyau de batterie (204, 204) par l'intermédiaire d'une ligne d'alimentation (217) et au bus CAN (210, 310), et comprenant un ou plusieurs modules de recharge (145, 241, 341) ;
un système de gestion de batterie (206, 306) connecté au chargeur de bloc-batterie (208, 308) par l'intermédiaire du bus CAN (210, 310) et de la ligne d'alimentation (217), et configuré pour commander un fonctionnement du chargeur de bloc-batterie (208, 308) et du chargeur de noyau de batterie (214, 314) ; et
une interface homme-machine (348) connectée au système de gestion de batterie (206, 306) par l'intermédiaire du bus CAN (210, 310) et configurée pour permettre à un utilisateur de générer un ou plusieurs ordres de commande ou demandes d'informations sur le bus CAN (210, 310) en vue de leur exécution par un ou plusieurs éléments parmi le système de gestion de batterie (206, 306), le chargeur de noyau de batterie (214, 314) et le chargeur de bloc-batterie (208, 308),
l'alimentation portable étant **caractérisée en ce que** le chargeur de bloc-batterie (208, 308) est connecté au bus CAN (210, 310) par l'intermédiaire d'une barrière à isolation galvanique (232, 332).

2. Alimentation portable (100) selon la revendication 1, la barrière à isolation galvanique (232, 332) étant un convertisseur CC/CC (344) qui isole en tension le chargeur de bloc-batterie (208, 308) du bus CAN (210, 310), le chargeur de bloc-batterie (208, 308) étant configuré pour recharger un bloc-batterie.

3. Alimentation portable (100) selon la revendication 1, le système de gestion de batterie (206, 306) étant configuré pour communiquer à la fois avec le chargeur de bloc-batterie (208, 308) et l'interface homme-machine (348) au moyen d'un protocole CAN.

4. Alimentation portable (100) selon la revendication 1, le système de gestion de batterie (206, 306) étant connecté au chargeur de bloc-batterie (208, 308) par l'intermédiaire d'un émetteur-récepteur CAN à isolation galvanique (230, 334).

5. Alimentation portable (100) selon la revendication 4, comprenant en outre un dispositif de commande électronique (336, 420) disposé dans le chargeur de bloc-batterie (208, 308) et connecté à l'émetteur-récepteur CAN (230, 334), le dispositif de commande électronique (336, 420) étant configuré pour déterminer qu'un port de recharge (238, 240, 338, 340) du ou des modules de recharge (145, 241, 341) est en cours d'utilisation.

6. Alimentation portable (100) selon la revendication 5, le dispositif de commande électronique (336, 420) étant en outre configuré pour déterminer un type d'un bloc-batterie connecté au port de recharge (238, 240, 338, 340).

7. Alimentation portable (100) selon la revendication 6, le dispositif de commande électronique (336, 420) étant en outre configuré pour :
déterminer un état de recharge d'un bloc-batterie connecté au port de recharge (238, 240, 338, 340) ; et
communiquer l'état de recharge à l'interface homme-machine (348) au moyen d'un protocole CAN,
l'état de recharge étant au moins un des états suivants : initialisation, récupération après décharge profonde, recharge principale à intensité constante, recharge progressive, recharge d'entretien, en attente de recharge, chargeur défectueux et chargeur trop chaud/trop froid.

8. Alimentation portable (100) selon la revendication 6, le dispositif de commande électronique (336, 420) étant en outre configuré pour :
déterminer un état de recharge d'un bloc-batterie connecté au port de recharge (238, 240, 338, 340) ; et
communiquer l'état de recharge à l'interface homme-machine (348) au moyen d'un protocole CAN, l'état de recharge étant au moins un des états suivants : pas de bloc présent, initialisation, récupération après décharge profonde, recharge principale à intensité constante, recharge progressive, recharge d'entretien, en attente de recharge, chargeur défectueux, bloc défectueux, bloc trop chaud/trop froid, chargeur trop chaud/trop froid et équilibrage des éléments de bloc.

9. Procédé de lancement d'une recharge d'un bloc-batterie au moyen d'une alimentation portable (100) comprenant un bus de réseau de commande (CAN) (210, 310), un noyau de batterie (204, 304), un chargeur de bloc-batterie (208, 308) connecté au noyau de batterie (204, 304) par l'intermédiaire d'une ligne d'alimentation et au bus CAN (210, 310) et comprenant un ou plusieurs modules de recharge (145, 241, 341), un système de gestion de batterie (206, 306) connecté au chargeur de bloc-batterie (208, 308) par l'intermédiaire du bus CAN (210, 310) et de la ligne d'alimentation, et une interface homme-machine (348) connectée au système de gestion de batterie (206, 306) par l'intermédiaire du bus CAN (210, 310), le procédé consistant à :
recharger, au moyen d'un chargeur de noyau de batterie (214, 314), le noyau de batterie (204, 304) ; commander, au moyen du système de gestion de batterie (206, 306), un fonctionnement du chargeur de bloc-batterie (208, 308) et du chargeur de noyau de batterie (214, 314) ; et
générer, sur la base d'une entrée d'utilisateur au niveau de l'interface homme-machine (348), un ou plusieurs ordres de commande ou demandes d'informations sur le bus CAN (210, 310) en vue de leur exécution par un ou plusieurs éléments parmi le système de gestion de batterie (206, 306), le chargeur de noyau de batterie (214, 314) et le chargeur de bloc-batterie (208, 308),
le procédé étant **caractérisé en ce que** le chargeur de bloc-batterie (208, 308) est connecté au bus CAN (210, 310) par l'intermédiaire d'une barrière à isolation galvanique (232, 332).

10. Procédé selon la revendication 9, consistant en outre à :
recevoir, au niveau d'un système de gestion de batterie (206, 306) par l'intermédiaire d'un bus CAN (210, 310), une notification d'une connexion d'un bloc-batterie, en provenance d'un chargeur de bloc-batterie (208, 308) ;
recevoir, au niveau du système de gestion de batterie (206, 306) par l'intermédiaire du bus CAN (210, 310), un ordre de démarrage de recharge, en provenance d'une interface homme-machine (348) ;
commander, par l'intermédiaire du système de gestion de batterie (206, 306), le chargeur de bloc-batterie (208, 308) pour démarrer la recharge du bloc-batterie sur la base de l'ordre de démarrage de recharge ; et
fournir, par l'intermédiaire du chargeur de bloc-batterie (208, 308), un courant de recharge en provenance d'une source d'alimentation au chargeur de bloc-batterie (208, 308) sur la base de l'ordre de démarrage de recharge.

11. Procédé selon la revendication 9, consistant en outre à :
recevoir, au niveau du système de gestion de batterie (206, 306), un état de recharge de bloc-batterie (208, 308) en provenance du chargeur de bloc-batterie (208, 308).

12. Procédé selon la revendication 9, le système de gestion de batterie (206, 306) et le chargeur de bloc-batterie (208, 308) étant tous deux intégrés à une source d'alimentation portable.

13. Procédé selon la revendication 9, le bus CAN (210, 310) étant intégré à une source d'alimentation portable.

14. Procédé selon la revendication 9, le chargeur de bloc-batterie (208, 308) étant isolé galvaniquement de la source d'alimentation par un convertisseur CC/CC qui isole en tension le chargeur de bloc-batterie (208, 308) du bus CAN (210, 310), le chargeur de bloc-batterie (208, 308) étant configuré pour recharger un bloc-batterie.

15. Procédé selon la revendication 9, le système de gestion de batterie (206, 306) étant connecté au chargeur de bloc-batterie (208, 308) par l'intermédiaire d'un émetteur-récepteur CAN à isolation galvanique (230, 334).
